# EUROPÄISCHE PATENTSCHRIFT

(11) **EP 3 185 659 B1**
(45) Veröffentlichungstag und Bekanntmachung des Hinweises auf die Patenterteilung: **19.03.2025**
(21) Anmeldenummer: 16202924.3
(22) Anmeldetag: 08.12.2016
(51) Int. Cl.: H05K 3/46, H05K 1/02, H05K 3/00, H05K 3/34

(54) **VERFAHREN ZUM HERSTELLEN EINES ELEKTRISCHEN SCHALTUNGSMODULS UND ELEKTRISCHES SCHALTUNGSMODUL**
METHOD FOR MANUFACTURING AN ELECTRICAL CIRCUIT MODULE AND ELECTRICAL CIRCUIT MODULE
PROCÉDÉ DE PRODUCTION D'UN MODULE DE COMMUTATION ÉLECTRIQUE ET MODULE DE COMMUTATION ÉLECTRIQUE

(30) Priorität: 21.12.2015 DE 102015226135
(43) Veröffentlichungstag der Anmeldung: 28.06.2017
(73) Patentinhaber: Robert Bosch GmbH, 70442 Stuttgart (DE)
(72) Erfinder: Kugler, Andreas, 73553 Alfdorf (DE)

(56) Entgegenhaltungen:
- WO-A2-2007/131256
- DE-A1- 102013 209 296
- US-A1- 2010 206 621
- US-A1- 2011 075 384
- US-A1- 2015 207 216

## Beschreibung

### Stand der Technik

Die Erfindung geht aus von einer Vorrichtung oder einem Verfahren nach Gattung der unabhängigen Ansprüche.

Ein wichtiges zukünftiges Feld für Radaranwendungen stellt die Automobilindustrie dar, wo in steigendem Maße der Einbau von Radarmodulen wie z. B. Hochfrequenz-Radarsensoren im kompletten Karosseriebereich des Fahrzeugs erforderlich sein wird, um eine komplette Umsicht des Fahrzeugs gewährleisten zu können. In diesem Zusammenhang gewinnt eine möglichst weit gehende Miniaturisierung der Radarmodule zunehmend an Bedeutung.

Die DE 10 2007 044 754 A1 zeigt ein Verfahren zur Herstellung einer elektronischen Baugruppe, bei dem ein auf einer Leiterplatte befestigtes elektronisches Bauelement auf eine isolierende Schicht einer leitfähigen Folie befestigt und kontaktiert wird, die dann wiederum mit dem daran befestigten elektronischen Bauelement auf einen Leiterplattenträger auflaminiert wird.

Aus der US 2015/207216 A1 ist ein Modul mit einem Substrat, auf dessen einer Seite eine Antenne und auf dessen anderer Seite eine hoch integrierte Mikrowellenschaltung angeordnet ist, bekannt.

Aus der US 2011/075384 A1 ist bekannt, dass empfindliche elektronische Komponenten auf einer Leiterplatte innerhalb eines elektronischen Geräts montiert werden können. Um ein empfindliches Bauteil von Spannungen zu isolieren, die bei einem unbeabsichtigten Aufprallereignis auftreten können, kann das elektronische Bauteil unter Verwendung einer Nut in der Leiterplatte isoliert werden. Das elektronische Bauteil kann an einem Bauteilmontagebereich mittels Lötpunkten montiert werden, der auf einigen oder allen Seiten von der Nut umgeben sein kann. Flexible Schaltungsstrukturen, die die Nut oder einen Abschnitt der starren gedruckten Schaltungsplatine überbrücken, können verwendet werden, um den Komponentenmontagebereich an Ort und Stelle zu halten. Die flexiblen Schaltungsstrukturen können in Form separater Strukturen bereitgestellt werden oder als integraler Teil der gedruckten Schaltungsplatine.

Die US 2010/206621 A1 zeigt eine Leiterplatte mit einer eingebauten Komponente, beinhaltend u.a. eine isolierende Platte, ein erstes Verdrahtungsmuster auf einer oberen Oberfläche der isolierenden Platte und mehrere Elektroden auf der oberen Oberfläche der isolierenden Platte Ein Lötlack umgibt die Elektroden.

### Offenbarung der Erfindung

Vor diesem Hintergrund werden mit dem hier vorgestellten Ansatz ein Verfahren zum Herstellen eines elektrischen Schaltungsmoduls sowie ein elektrisches Schaltungsmodul gemäß den Hauptansprüchen vorgestellt. Durch die in den abhängigen Ansprüchen aufgeführten Maßnahmen sind vorteilhafte Weiterbildungen und Verbesserungen der im unabhängigen Anspruch angegebenen Vorrichtung möglich.

Im Aufbau eines Radarmoduls ermöglicht eine Anordnung einer Kontaktierseite einer in Embedded-Wafer-Level-Ball-Grid-Array-Technologie hergestellten elektronischen Schaltung an einer zweiten Hauptseite eines Schaltungsträgers, an dessen erster Hauptseite zumindest ein Antennenelement angeordnet ist, eine erheblich gesteigerte Flächennutzung auf dem elektronischen Schaltungsträger und damit eine vorteilhafte Miniaturisierung des Radarmoduls.

Es wird ein Verfahren zum Herstellen eines elektrischen Schaltungsmoduls mit folgenden Schritten vorgestellt:
Bereitstellen eines Schaltungsträgers mit zumindest einem auf einer ersten Hauptseite des Schaltungsträgers angeordneten Antennenelement zum Aussenden elektromagnetischer Strahlung und zumindest einem auf einer zweiten Hauptseite des Schaltungsträgers angeordneten elektrischen Kontakt;
Bereitstellen einer in Embedded-Wafer-Level-Ball-Grid-Array-Technologie hergestellten elektronischen Schaltung; und
Anordnen der elektronischen Schaltung mit einer Kontaktierseite der elektronischen Schaltung an der zweiten Hauptseite des Schaltungsträgers, um die Kontaktierseite mit dem elektrischen Kontakt elektrisch leitfähig zu kontaktieren.

Das elektrische Schaltungsmodul kann auch als elektrische Schaltungsvorrichtung bezeichnet werden und kann beispielsweise in einem Fahrzeug zur Radarerfassung eines Umfelds des Fahrzeugs eingesetzt werden. Das elektrische Schaltungsmodul kann gemäß einer Ausführungsform mehrere elektrische und/oder elektronische Bauelemente sowie Träger für die Bauelemente umfassen. Bei dem Schaltungsträger kann es sich um ein Substrat für die mechanische Befestigung und elektrische Anbindung der elektronischen Schaltung und gegebenenfalls weiterer Bauelemente handeln. Der Schaltungsträger kann für die elektrische Anbindung eine Mehrzahl von elektrischen Kontakten in Form elektrisch leitfähiger Schichten oder Lagen insbesondere an der zweiten Hauptseite aufweisen. Die Hauptseiten des Schaltungsträgers können durch die Seiten mit den größten Abmessungen des Schaltungsträgers repräsentiert sein. Das Antennenelement kann in Form einer flächigen Antennenstruktur an der ersten Hauptseite des Schaltungsträgers vorliegen.

Bei der elektronischen Schaltung kann es sich beispielsweise um eine integrierte Schaltung oder ein Halbleiterbauelement handeln. Unter der Embedded-Wafer-Level-Ball-Grid-Array-Technologie, kurz eWLB-Technologie, ist eine spezielle Gehäusebauform für elektronische Schaltungen, insbesondere integrierte Schaltungen, zu verstehen, bei der eine Vielzahl von Kontakten auf dem Halbleiterplättchen der elektronischen Schaltung untergebracht werden kann, indem das Gehäuse der Schaltung auf einem künstlichen Wafer hergestellt ist, der durch eine um das Halbleiterplättchen gebildete Vergussmasse zusätzlichen Platz für weitere Lötkontakte bereitstellen kann. Insbesondere handelt es sich bei der elektronischen Schaltung um eine, insbesondere in Embedded-Wafer-Level-Ball-Grid-Array-Technologie hergestellten, elektronischen Hochfrequenzschaltung.

Bei der Kontaktierseite der elektronischen Schaltung kann es sich um eine elektrisch aktive oder aktivierbare, zumindest einen elektrischen Kontakt aufweisende, Seite der elektronischen Schaltung handeln.

Das Verfahren kann voll- oder teilautomatisiert von einem Handlingroboter ausgeführt werden.

Das hier vorgeschlagene Schaltungskonzept ermöglicht eine komplette Kapselung empfindlicher Bauelemente und zeichnet sich dadurch durch eine hohe Zuverlässigkeit aus. Ferner kann kostenintensive Substrat- und Packagetechnik ersetzt bzw. auf ein kleines Bauteil reduziert werden. Auch ist eine kostengünstige Herstellung des elektrischen Schaltungsmoduls durch Ausführen eines Batchprozesses in Panelgrößen mit leiterplattenähnlichen Technologien möglich.

Es können gemäß dem hier vorgestellten Konzept elektrische Schaltungen bzw. Schaltungsmodule mit nachweislich hoher Zuverlässigkeit hergestellt werden, bei denen auch Leitungsüberkreuzungen durch Integration einer oder mehrerer Leitungsebenen realisierbar sind.

In einer Weiterbildung des hier vorgeschlagenen Ansatzes ist beispielsweise eine Integration von gegebenenfalls notwendigen Kühlkörpern oder thermischen Vias in das elektrische Schaltungsmodul ohne Weiteres realisierbar.

Erfindungsgemäß wird in dem Schritt des Bereitstellens eines Schaltungsträgers der Schaltungsträger mit zumindest einer ersten Schaltungsträgerlage und einer auf die erste Schaltungsträgerlage auflaminierten zweiten Schaltungsträgerlage bereitgestellt. Dabei weist die erste Schaltungsträgerlage die erste Hauptseite des Schaltungsträgers auf und die zweite Schaltungsträgerlage die zweite Hauptseite des Schaltungsträgers. So kann der Schaltungsträger ohne Weiteres in einer spezifikationsabhängigen Höhe hergestellt und insbesondere mit zwischen Schaltungsträgerlagen einlaminierten elektrischen Leitungen bereitgestellt werden.

Insbesondere kann in dem Schritt des Bereitstellens eines Schaltungsträgers die erste Schaltungsträgerlage ein Material mit einer Dielektrizitätszahl in einem Bereich zwischen 2,5 und 3,5, insbesondere mit einer Dielektrizitätszahl von 3, und/oder mit einem Verlustfaktorwert in einem Bereich zwischen 0,0010 und 0,0025, insbesondere mit einem Verlustfaktorwert von 0,0017 aufweisen. Mit dieser Ausführungsform können optimale Hochfrequenzeigenschaften des Schaltungsträgers gewährleistet werden.

Günstig ist es auch, wenn in dem Schritt des Bereitstellens eines Schaltungsträgers die zweite Schaltungsträgerlage ein mit Reaktionsharzen vorimprägniertes textiles Halbzeug aufweist. Auf diese Weise kann der Schaltungsträger schnell und kostengünstig gefertigt werden.

Auch wird in dem Schritt des Bereitstellens eines Schaltungsträgers die erste Schaltungsträgerlage und die zweite Schaltungsträgerlage als eine Folie ausgebildet bereitgestellt. Dem Schaltungsträger kann damit neben einer geringen Bauhöhe eine vorteilhafte Flexibilität und Verformbarkeit verliehen werden.

Weiterhin wird in dem Schritt des Bereitstellens eines Schaltungsträgers die erste Schaltungsträgerlage und/oder die zweite Schaltungsträgerlage mit einer Dicke im Bereich zwischen 25 µm und 150 µm bereitgestellt. So kann der Schaltungsträger spezifikationsabhängig mit einem optimalen Ausgleich zwischen geringer Bauhöhe und optimalen Hochfrequenzeigenschaften realisiert werden.

Gemäß einer weiteren Ausführungsform kann in dem Schritt des Bereitstellens eines Schaltungsträgers der Schaltungsträger mit zumindest einer zwischen der ersten Schaltungsträgerlage und der zweiten Schaltungsträgerlage einlaminierten elektrischen Leitung bereitgestellt werden. Auf diese Weise können die Kontaktiermöglichkeiten des elektrischen Schaltungsmoduls ohne Weiteres erhöht und verbessert werden.

Das Verfahren kann einen Schritt des Herstellens des Schaltungsträgers aufweisen. Dabei kann eine erste Schaltungsträgerlage für den Schaltungsträger bereitgestellt werden und eine zweite Schaltungsträgerlage für den Schaltungsträger auf die erste Schaltungsträgerlage auflaminiert werden, um die erste Schaltungsträgerlage und die zweite Schaltungsträgerlage stoffschlüssig zu verbinden.

Gemäß einer weiteren Ausführungsform kann das Verfahren einen Schritt des Fixierens der elektronischen Schaltung an dem Schaltungsträger aufweisen, um die elektronische Schaltung dauerhaft an dem Schaltungsträger zu befestigen. Neben einem optimalen Stromübergang kann damit eine Robustheit des elektrischen Schaltungsmoduls im Einsatz gewährleistet werden.

Beispielsweise kann in dem Schritt des Fixierens zumindest ein an der Kontaktierseite der elektronischen Schaltung angeordneter Kontaktierhügel der elektronischen Schaltung mittels FlipChip-Montagetechnik an den elektrischen Kontakt des Schaltungsträgers angebracht oder kontaktiert werden beispielsweise durch Anlöten, Ankleben oder Angeschweißen. Gemäß dieser Ausführungsform kann vorteilhafterweise auf zusätzliche Bonddrähte zur elektrischen Kontaktierung der elektronischen Schaltung verzichtet werden.

Alternativ kann in dem Schritt des Fixierens zumindest eine an der Kontaktierseite der elektronischen Schaltung angeordnete elektrische Leitung der elektronischen Schaltung galvanisch an den elektrischen Kontakt des Schaltungsträgers ankontaktiert werden. Auch bei dieser besonders schnellen und kostengünstigen Fixierungsmethode kann auf Bonddrähte verzichtet werden.

Das Verfahren kann ferner einen Schritt des Auflegens des Schaltungsträgers mit der zweiten Hauptseite auf ein flüssiges oder pastöses Verbundmaterial aufweisen, um eine die elektronische Schaltung einbettende Leiterplatte des elektronischen Schaltungsmoduls zu bilden. So kann die elektronische Schaltung vorteilhafterweise vollständig von Leiterplattenmaterial umgeben und vor Beschädigungen optimal geschützt werden.

Beispielsweise kann es sich bei dem Verbundmaterial um einen Werkstoff handeln, der Epoxidharz und Glasfasergewebe aufweist. Mit dieser Ausführungsform kann die Leiterplatte robust und kostengünstig realisiert werden.

Günstig kann es auch sein, wenn das Verfahren einen Schritt des Ausfräsens eines seitlich an die elektronische Schaltung angrenzenden Teilbereichs zumindest des Schaltungsträgers aufweist. So kann die elektronische Schaltung zumindest teilweise seitlich freigelegt werden und leichter dreidimensional verformt werden. Ferner wird ein Abbiegen von Antennenstrukturen ermöglicht.

Es wird ferner ein elektrisches Schaltungsmodul mit folgenden Merkmalen vorgestellt:
einem Schaltungsträger mit zumindest einem auf einer ersten Hauptseite des Schaltungsträgers angeordneten Antennenelement zum Aussenden elektromagnetischer Strahlung und zumindest einem auf einer zweiten Hauptseite des Schaltungsträgers angeordneten elektrischen Kontakt; und
einer in Embedded-Wafer-Level-Ball-Grid-Array-Technologie hergestellten elektronischen Schaltung, insbesondere eine, insbesondere in Embedded-Wafer-Level-Ball-Grid-Array-Technologie hergestellten, elektronischen Hochfrequenzschaltung, die mit einer Kontaktierseite der elektronischen Schaltung an der zweiten Hauptseite des Schaltungsträgers angeordnet ist und den elektrischen Kontakt elektrisch leitfähig kontaktiert.

Auch durch diese Ausführungsvariante der Erfindung in Form eines elektrischen Schaltungsmoduls kann die der Erfindung zugrunde liegende Aufgabe schnell und effizient gelöst werden.

Ausführungsbeispiele der Erfindung sind in den Zeichnungen dargestellt und in der nachfolgenden Beschreibung näher erläutert. Es zeigt:
Fig. 1 eine schematische Darstellung eines elektrischen Schaltungsmoduls gemäß einem Ausführungsbeispiel;
Fig. 2 ein Ablaufdiagramm eines Verfahrens zum Herstellen eines elektrischen Schaltungsmoduls gemäß einem Ausführungsbeispiel;
Fig. 3 eine schematische Darstellung eines elektrischen Schaltungsmoduls gemäß einem weiteren Ausführungsbeispiel;
Fig. 4 eine Darstellung eines elektrischen Schaltungsmoduls im Semiflex-Aufbau gemäß einem Ausführungsbeispiel;
Fig. 5 einen Detailausschnitt des in Fig. 4 gezeigten Schaltungsmoduls im Semiflex-Aufbau; und
Fig. 6 eine schematische Darstellung eines Fahrzeugs mit einem in ein Karosserieteil des Fahrzeugs integrierten elektrischen Schaltungsmodul gemäß einem Ausführungsbeispiel.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

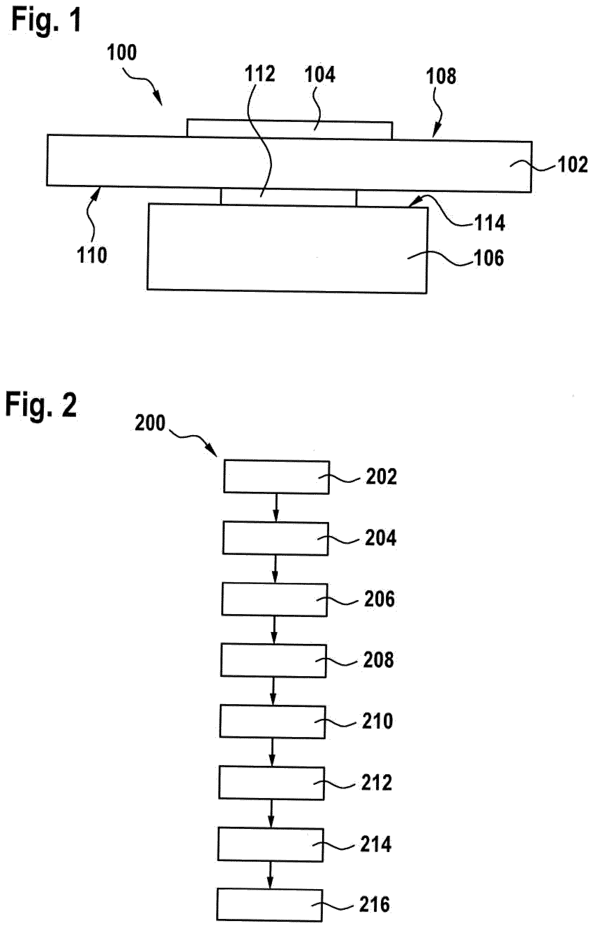

Fig. 1 zeigt eine schematische Darstellung eines elektrischen Schaltungsmoduls 100 gemäß einem Ausführungsbeispiel des hier vorgestellten Konzepts. Das elektrische Schaltungsmodul 100 kann beispielsweise in Kombination mit einem Steuergerät für ein Fahrzeug als Radarsensor oder Teil eines Radarsensors eingesetzt werden und weist einen Schaltungsträger 102, ein Antennenelement 104 und eine elektronische Schaltung 106 auf.

Das Antennenelement 104 ist in Form einer flächigen Antennenstruktur ausgebildet und an einer ersten Hauptseite 108 des Schaltungsträgers 102 angeordnet. Beispielsweise liegt das Antennenelement 104 in Form einer Folie vor. Das Antennenelement 104 ist ausgebildet, um eine elektromagnetische Strahlung im Hochfrequenzbereich auszusenden. An einer der ersten Hauptseite 108 gegenüberliegenden zweiten Hauptseite 110 weist der Schaltungsträger 102 einen elektrischen Kontakt 112 in Form einer Leiterbahn auf.

Die elektronische Schaltung 106 weist an einer Hauptseite eine Kontaktierseite 114 auf und ist mit der Kontaktierseite 114 den elektrischen Kontakt 112 elektrisch leitfähig kontaktierend an der zweiten Hauptseite 110 des Schaltungsträgers 102 angeordnet. Bei der beispielhaften elektronischen Schaltung 106 handelt es sich in Fig. 1 um eine integrierte Schaltung (IC). Der IC 106 ist beispielsweise ausgebildet, um das Antennenelement 104 mit elektrischer Leistung zu versorgen. Der IC 106 ist in der oben erläuterten Embedded-Wafer-Level-Ball-Grid-Array-Technologie bzw. eWLB-Technologie hergestellt und weist entsprechend an der Kontaktierseite 114 eine Vielzahl von elektrischen Kontakten auf.

Bei dem in Fig. 1 gezeigten Ausführungsbeispiel des elektrischen Schaltungsmoduls 100 ist die elektronische Schaltung 106 mit der Kontaktierseite 114 galvanisch an den elektrischen Kontakt 112 des Schaltungsträgers 102 ankontaktiert und somit dauerhaft und mit großer Stromübergangsfläche an dem Schaltungsträger 102 fixiert.

Fig. 2 zeigt ein Ablaufdiagramm eines Verfahrens 200 zum Herstellen eines elektrischen Schaltungsmoduls. Das Verfahren 200 kann zum Herstellen einer Variante des in Fig. 1 gezeigten elektrischen Schaltungsmoduls manuell oder mittels eines Handlingroboters ausgeführt werden.

In einem Schritt des Herstellens 202 wird ein strukturierter Schaltungsträger in bekannter Flex-Folientechnologie hergestellt. Insbesondere wird im Schritt des Herstellens 202 der Schaltungsträger als ein Laminat aus mehreren Schaltungsträgerlagen bzw. -folien aus gleichen oder unterschiedlichen Materialien gebildet. Vorzugsweise wird hierbei ein Substratmaterial mit einer niedrigen Dielektrizitätszahl und einem geringen Verlustfaktor als Dielektrikum eingesetzt, da hier geeignete für eine Mehrlagenbildung des Schaltungsträgers erforderliche Prepreg-Materialien verfügbar sind. Die einzelnen Lagen werden in Abhängigkeit der spezifischen Hochfrequenzanforderung in einer vorbestimmten Dicke in einem Bereich zwischen 25 µm und 150 µm hergestellt, sodass eine maximale Gesamtdicke des Schaltungsträgers ca. 300 µm beträgt. Der im Schritt 202 hergestellte Schaltungsträger wird auch als sogenannter Interposer bezeichnet.

Gemäß einem Ausführungsbeispiel wird im Schritt des Herstellens 202 zumindest ein Antennenelement an einer ersten Hauptseite des Schaltungsträgers angebracht, und es werden ferner elektrische Kontakte insbesondere an einer zweiten Hauptseite des Schaltungsträgers strukturiert bzw. angebracht. Auch können im Schritt des Herstellens 202 elektrische Kontakte bzw. elektrische Leitungen zwischen einzelnen Lagen des Schaltungsträgers einlaminiert werden.

In einem Schritt des Bereitstellens 204 wird der Schaltungsträger bereitgestellt. In einem weiteren Schritt des Bereitstellens 206 wird mindestens eine in Embedded-Wafer-Level-Ball-Grid-Array-Technologie hergestellte elektronische Schaltung bereitgestellt.

In einem folgenden Schritt des Anordnens 208 wird das Antennenelement an einer ersten Hauptseite des Schaltungsträgers angeordnet und die elektronische Schaltung so an der zweiten Hauptseite des Schaltungsträgers angeordnet, dass sie mit einer Kontaktierseite den elektrischen Kontakt des Schaltungsträgers kontaktiert.

In einem Schritt des Fixierens 210 werden die elektronische Schaltung und gegebenenfalls weitere elektrische oder elektronische Hochfrequenzkomponenten an dem Schaltungsträger montiert und fixiert. Hier sind bekannte Technologien wie das Löten des Packages bzw. ICs möglich. Alternativ kann durch Weglassen der Kontaktierungshügel am Package eine Kontaktierung direkt bei der Herstellung der Leiterstrukturen und einer gegebenenfalls ausgeführten Prozessierung von Vias in dem Schaltungsträger durch galvanische Kontakte gewählt werden.

In einem Schritt des Auflegens 212 wird der Schaltungsträger bzw. Interposer mit der zweiten Hauptseite auf ein flüssiges oder pastöses Verbundmaterial aufgelegt, um den Interposer in Leiterplattentechnologie auf weitere Leiterplattenkerne zu laminieren und zu kontaktieren. Die elektronische Schaltung ist abschließend in der Leiterplatte eingebettet.

In einem optionalen Schritt des Ausfräsens 214 werden zur Bildung von sogenannten Semiflex-Bereichen des elektrischen Schaltungsmoduls Bereiche seitlich der elektronischen Schaltung freigefräst.

In einem beispielhaften abschließenden Schritt 216 des Verfahrens 200 wird für eine mögliche Anbindung des elektrischen Schaltungsmoduls an eine Spannungsquelle ein Steckverbinder an die fertige Leiterplatte montiert.

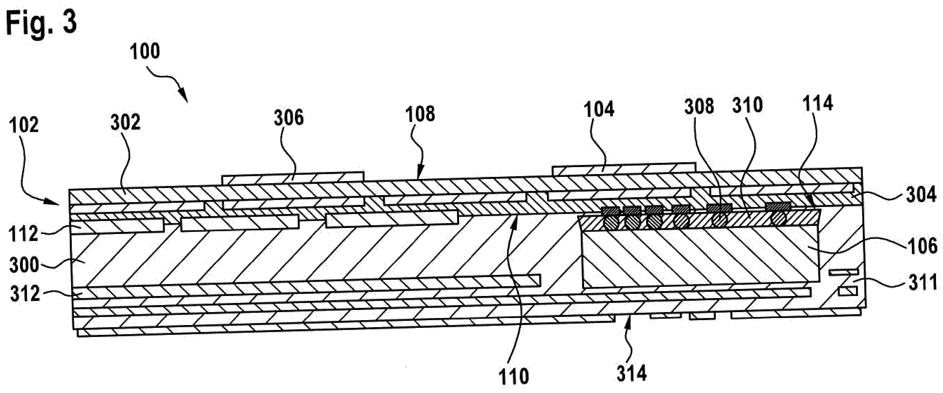

Fig. 3 zeigt eine schematische Darstellung eines weiteren Ausführungsbeispiels des gemäß dem hier vorgeschlagenen Ansatz in Einbett-Technologie hergestellten elektrischen Schaltungsmoduls bzw. Hochfrequenzmoduls 100. Fig. 3 zeigt eine Variante des Schaltungsmoduls 100, bei der der Schaltungsträger 102 eine Oberseite des fertig gestellten Leiterplattenmoduls bildet und die elektronische Schaltung 106 in eine Verbundmasse 300 des Leiterplattenmoduls eingebettet ist.

Der Schaltungsträger 102 liegt, wie oben bereits erläutert, als ein Laminat vor und umfasst eine erste Schaltungsträgerlage 302 und eine auf die erste Schaltungsträgerlage 302 auflaminierte zweite Schaltungsträgerlage 304. Beide Schaltungsträgerlagen 302, 304 liegen in Form von Folien mit einer Dicke im Bereich zwischen 25 µm und 150 µm vor. Beispielsweise weist die erste Schaltungsträgerlage 302 eine Dicke von 50 µm auf und die zweite Schaltungsträgerlage 304 eine Dicke von 75 µm auf. Der gesamte Schaltungsträger 102 liegt damit in einer Dicke von 125 µm vor. Die Schaltungsträgerlagen 302, 304 können jeweils aus einer Lage oder aus mehreren Lagen des jeweils verwendeten Laminatmaterials gebildet sein.

Eine von der zweiten Schaltungsträgerlage 304 abgewandte Hauptseite der ersten Schaltungsträgerlage 302 bildet die erste Hauptseite 108 des Schaltungsträgers 102, und eine von der ersten Schaltungsträgerlage 302 abgewandten Hauptseite der zweiten Schaltungsträgerlage 304 bildet die zweite Hauptseite 110 des Schaltungsträgers 102.

Bei dem in Fig. 3 gezeigten Ausführungsbeispiel des Hochfrequenzmoduls 100 wurde die das Dielektrikum oder einen Teil des Dielektrikums des Schaltungsträgers 102 bildende erste Schaltungsträgerlage 302 aus einem Material mit einer Dielektrizitätszahl von 3 gefertigt. Allgemein als vorteilhaft gilt hier die Verwendung eines Materials mit einer Dielektrizitätszahl in einem Bereich zwischen 2,5 und 3,5.

Konkret wurde bei dem in Fig. 3 gezeigten Ausführungsbeispiel ein Laminat zur Herstellung der ersten Schaltungsträgerlage 302 verwendet, das hochwertige Substratmaterialien mit besonderen Werkstoffeigenschaften aufweist. Zu den erforderlichen Eigenschaften des zu verwendenden Materials für die erste Schaltungsträgerlage 302 zählen für eine Eignung des Materials für Anwendungen insbesondere im Millimeterwellenfrequenzbereich eine möglichst verlustarme Dielektrizitätszahl, weiterhin dielektrische Eigenschaften, die über einen großen Frequenz- und Temperaturbereich stabil sind, eine Dielektrizitätskonstante, die bis zu 20 GHz zwischen -55 und +125 °C stabil ist, sowie ein geringer Verlustfaktor von bestenfalls 0,0017.

Als Material für die zweite Schaltungsträgerlage 304 kommt bei dem in Fig. 3 gezeigten Ausführungsbeispiel des elektrischen Schaltungsmoduls 100 zur Bildung eines Backplanes für die erste Schaltungsträgerlage 302 ein hochfrequenzfähiges sogenanntes Prepreg-Material zum Einsatz. Bei dem Prepreg-Material (Prepreg: kurz für preimpregnated fibres = vorimprägnierte Fasern) handelt es sich beispielsweise um einen Verbundwerkstoff aus Fasern, die als Gewebe vorliegen, und vorvernetzten Reaktionsharzen, mit denen die Fasern vorimprägniert sind. Die aus dem Prepreg-Material als textiles Halbzeug gebildete zweite Schaltungsträgerlage 304 wird im Herstellungsprozess des Schaltungsträgers 102 unter Temperatur und Druck ausgehärtet und fest mit der ersten Schaltungsträgerlage 302 verbunden bzw. auf diese auflaminiert. Zur Bildung eines Laminats kann eine aus einem ersten geeigneten Material hergestellte erste Schaltungsträgerlage 302 mit einer zweiten Schaltungsträgerlage 304 aus einem weiteren Material kombiniert werden, das sich von dem ersten Material unterscheidet. Als Material für die zweite Schaltungsträgerlage 304 ist auch eine Kombination aus verschienen Werkstoffen denkbar, z. B. auch einem Ro3003-HF-Material.

Bei dem in Fig. 3 gezeigten Ausführungsbeispiel des elektrischen Schaltungsmoduls 100 ist an der ersten Hauptseite 108 des Schaltungsträgers 102 beabstandet von dem ersten Antennenelement 104 ein zweites Antennenelement 306 angeordnet. Bei den Antennenelementen 104, 306 handelt es sich um flache folienförmige Antennenstrukturen 104, 306. Die Antennenelemente 104, 306 bilden gemeinsam eine breitbandige Antenne des elektrischen Schaltungsmoduls 100 zum Aussenden einer Radarstrahlung.

An der zweiten Hauptseite 110 des Schaltungsträgers 102 sind elektrische Kontakte 112 in Form von Leiterbahnen unterschiedlicher Länge und in unterschiedlichen Abständen angeordnet bzw. strukturiert. Ferner sind bei dem in Fig. 3 gezeigten Ausführungsbeispiel des elektrischen Schaltungsmoduls 100 eine Mehrzahl von fünf weiteren elektrischen Kontakten 112 in Form von voneinander beabstandeten elektrischen Leitern in geringer Beabstandung von der ersten Schaltungsträgerlage 302 in die zweite Schaltungsträgerlage 304 einlaminiert.

Die in Embedded-Wafer-Level-Ball-Grid-Array-Technologie hergestellte elektronische Schaltung bzw. Hochfrequenzschaltung 106 ist bei dem in Fig. 3 gezeigten Ausführungsbeispiel als ein MMIC (monolithic microwave integrated circuit; dt. monolithische Mikrowellenschaltung) ausgeführt. Der MMIC 106 ist den Antennenelementen 104, 306 gegenüberliegend an der Unterseite bzw. zweiten Hauptseite 110 des Schaltungsträgers 102 angeordnet. Der MMIC 106 ist so an der zweiten Hauptseite 110 positioniert, dass er sich bezogen auf den Schaltungsträger 102 teilweise mit dem ersten Antennenelement 104 überlappt.

Bei dem in Fig. 3 gezeigten Ausführungsbeispiel ist der MMIC 106 in FlipChip-Montagetechnik an der Unterseite 110 des Schaltungsträgers 102 montiert. Hier sind aufgrund des in der eWLB-Technologie gefertigten MMICs 106 an der Kontaktierseite 114 des MMICs 106 zahlreich vorhandene Kontaktierhügel 308 beispielsweise mittels Lötverbindungen an entsprechend an der zweiten Hauptseite 110 des Schaltungsträgers 102 positionierten elektrischen Kontakten 112 ankontaktiert. Beispielsweise entspricht eine Anzahl der elektrischen Kontakte 112 einer Anzahl der an der Kontaktierseite 114 der elektronischen Schaltung 106 vorliegenden Lötpunkte bzw. Kontaktierhügel 308.

Bei dem in Fig. 3 gezeigten Ausführungsbeispiel ist ein durch eine Höhe der Kontaktierhügel 308 vorgegebener Zwischenraum zwischen der Kontaktierseite 114 des MMIC 106 und der zweiten Hauptseite 110 des Schaltungsträgers 102 mittels eines sogenannten Underfillers 310 ausgefüllt. Bei dem Underfiller 310 handelt es sich gemäß Ausführungsbeispielen um einen leitfähigen oder nicht leitfähigen Klebstoff, beispielsweise einen NCA-Klebstoff. Der Underfillprozess kann auch durch entsprechende Laminierparameter direkt mit dem Lamierharzmaterial durchgeführt sein.

Bei dem in Fig. 3 gezeigten beispielhaften Hochfrequenzmodul 100 ist bildet der Schaltungsträger 102 in Verbindung mit dem Verbundmaterial 300 eine Leiterplatte 311, bei der die elektronische Schaltung 106 in eine oder mehrere Schichten des Verbundmaterials 300 eingebettet ist, die an die zweite Hauptseite 110 des Schaltungsträgers 102 anschließen. Bei dem für das elektrische Schaltungsmodul 100 in Fig. 3 verwendeten Verbundmaterial 300 handelt es sich um einen Verbundwerkstoff, der Epoxidharz und Glasfasergewebe aufweist. Insbesondere handelt es sich bei dem Verbundmaterial 300 um einen Werkstoff der FR4-Klasse, der durch seine schwere Entflammbarkeit und flammenhemmenden Eigenschaften gekennzeichnet ist.

Bei der Herstellung des elektrischen Schaltungsmoduls 100 wurde der Verbundwerkstoff 300 in einem pastösen oder flüssigen Zustand mit dem Schaltungsträger 102 zusammengeführt, indem der Schaltungsträger bzw. Interposer 102 mit der zweiten Hauptseite 110 auf die Verbundmasse 300 aufgelegt und die elektronische Schaltung 106 in die Verbundmasse 300 hineingedrückt wurde. Anschließend wurde der Schaltungsträger 102 auf die Verbundmasse 300 auflaminiert. In dem in Fig. 3 gezeigten ausgehärteten Zustand der Leiterplatte 311 ist die elektronische Schaltung 106 damit mit Ausnahme der Kontaktierseite 114 an allen Seiten fest von dem Verbundmaterial 300 umschlossen und darin eingebettet.

Bei dem in Fig. 3 gezeigten Ausführungsbeispiels der Hochfrequenzschaltung 100 sind zur Entwärmung der elektrischen und/oder elektronischen Komponenten, insbesondere des MMICs 106, Metallbauteile 312 in Form von Metalllagen in den Verbundwerkstoff 300 eingebracht bzw. einlaminiert. So kann die elektronische Schaltung 106 vorteilhafterweise insbesondere über ihre der Kontaktierseite 114 gegenüberliegende Rückseite entwärmt werden, aber auch durch sogenannten thermische Bumps auf der Vorderseite. Anstelle der Metalllagen 112 oder zusätzlich zu den Metalllagen 112 können gemäß Ausführungsbeispielen weitere elektrische Kontakte 112 in den Verbundwerkstoff 300 eingearbeitet sein.

Bei dem in Fig. 3 gezeigten Ausführungsbeispiel des elektronischen Schaltungsmoduls 100 sind auf einer von dem Schaltungsträger 102 abgewandten Hauptseite 314 der Schicht des Leiterplattenverbundwerkstoffs 300 weitere Leiterbahnen 112 und/oder Metalllagen 312 vorgesehen.

Insgesamt weist das in Fig. 3 gezeigte beispielhafte Hochfrequenzmodul 100 inklusive der Antennenstrukturen 104, 306 zehn Lagen auf, wobei die Antennenstrukturen 104, 306 eine erste Lage, die erste Schaltungsträgerlage 302 eine zweite Lage, die zwischen die Schaltungsträgerlagen 302, 304 laminierten elektrischen Kontakte 112 eine dritte Lage, die zweite Schaltungsträgerlage 304 eine vierte Lage, die auf einer an den Schaltungsträger 102 angrenzenden Hauptseite der Verbundmassenschicht 300 angeordneten elektrischen Kontakte 112 eine fünfte Lage, die Verbundmassenschicht 300 eine sechste Lage, eine erste Metalllage 312 in der Verbundmassenschicht 300 eine siebte Lage, eine zweite Metalllage in der Verbundmassenschicht 300 eine achte Lage, die zweite Hauptseite 314 der Verbundmasse 300 eine neunte Lage und die an der Hauptseite 314 der Verbundmassenschicht 300 angeordneten elektrischen Kontakte 112 eine zehnte Lage des Moduls 100 bildet.

Bei dem in Fig. 3 gezeigten Ausführungsbeispiel des elektrischen Schaltungsmoduls 100 wurde Kupfer als Material für die elektrischen Kontakte bzw. Leiterbahnen 112 und die Metallbauteile 312 verwendet. Es können auch andere Materialien mit guter Konduktivität eingesetzt werden.

Die Darstellung des gemäß dem hierin vorgeschlagenen Konzept des Einbettens von Radar-eWLB-Packages 106 und der Herstellung mehrlagiger HF-Strukturen 102, 300 aufgebauten Hochfrequenzmoduls 100 in Fig. 3 veranschaulicht die erheblich gesteigerte Flächennutzung auf dem elektronischen Schaltungsträger 102, indem der Hochfrequenz-IC 106 und gegebenenfalls Auswerteelektronik unterhalb der Antennenstrukturen 104, 306 angebracht sind. Abmaße der Antennen 104, 306 bestimmen dabei die Größe des Packages 106. Die komplette Kapselung empfindlicher Bauelemente wie des ICs 106 schafft eine hohe Zuverlässigkeit des elektrischen Schaltungsmoduls 100. Insbesondere kann durch die hier vorgeschlagene Technologie aufgrund der Belastung durch die Montage des Hochfrequenz-ICs 106 die Kupferhaftung auf den Substratmaterialien 300, 302, 304 deutlich verbessert werden.

Der insbesondere in Fig. 3 gezeigte mehrlagige Aufbau der Hochfrequenzsubstrate 300, 302, 304 ermöglicht die vorteilhafte erhöhe Miniaturisierung des Radarmoduls 100. Insbesondere ermöglichen die verwendeten Prepreg-Materialien die Herstellung einer oder mehrerer übereinanderliegender hochfrequenztauglicher Lagen 304. Gemäß dem hier vorgestellten Konzept kann der Radar-IC106 direkt auf einer dieser Lagen 304 montiert werden, ohne hierfür Fläche auf der Oberseite 108 des Schaltungsträgers 102 zu benötigen, wo die flächenbestimmenden Antennen 104, 306 angebracht sind. Hierzu wird, wie in Fig. 3 gezeigt, der gehäuste eWLB-Radar-IC 106 auf die Unterseite 110 des Hochfrequenzstapels 102 montiert und dann bei der Herstellung der restlichen Leiterplatte 311 in die Leiterplatte 311 einlaminiert.

Gemäß dem hier vorgestellten Schaltungskonzept kann damit auf den Einsatz von speziell vorbereiteten Leiterplatten, die z. B. Kavitäten aufweisen müssen, sowie auf diverse aufwendige Drahtbondverbindungen verzichtet werden. Auch aufwendige und für die Hochfrequenz-Performance negative hochfrequenztaugliche Durchkontaktierungen durch die Leiterplatte 311 sind nicht notwendig.

Durch die Fertigung des hier gezeigten Hochfrequenzmoduls 100 in der Flex-Folientechnologie kann das fertige Modul 100 trotz der relativ großen Höhe in den Raumrichtungen verformt werden, z. B. für einen Einbau in komplex oder gebogen geformten Karosserieteilen eines Fahrzeugs.

Außerdem ermöglicht das Freifräsen an Teilen des Schaltungsträgers 102 ein Abbiegen von Antennenstrukturen auf dem HF-Laminat 302.

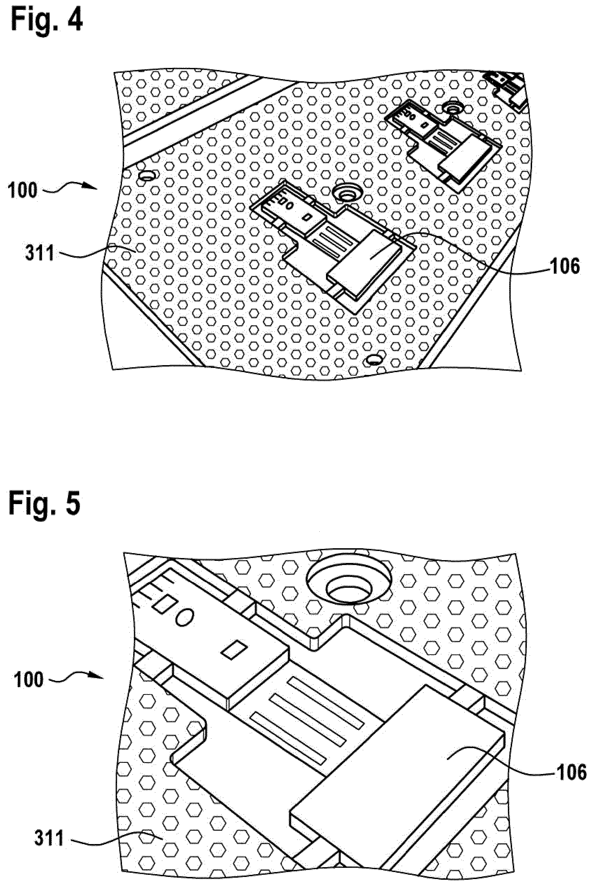

Fig. 4 zeigt eine Darstellung einer Variante des elektrischen Schaltungsmoduls 100 im sogenannten SemiFlex-Aufbau. Dabei sind seitlich an die elektronische Schaltung 106 angrenzende Teilbereiche der Leiterplatte 311 weggefräst und die elektronische Schaltung 106 damit bis auf schmale Stege zum Tragen der elektronischen Schaltung 106 freigelegt. Diese in Fig. 4 gezeigte nachträgliche Bearbeitung des fertigen Hochfrequenzmoduls 100 ermöglicht eine Verformbarkeit der Leiterplatte 311, von der der Hochfrequenz-IC 106 ausgenommen und damit vor einer Bruchgefahr geschützt ist. Eine derartig verformbare Leiterplatte 311 kann ohne Weiteres in kleine und verwinkelte Bauräume z. B. in einer Fahrzeugkarosserie eingebracht werden. Der in Fig. 4 gezeigte SemiFlex-Aufbau kann auch als Montageflex-Aufbau bezeichnet werden.

Benutzt man die äußeren Lagen, vorzugsweise die der Rückseite der Leiterplatte 311, als sogenannte Basislagen für eine sogenannte SemiFlex-Lage, können diese mittels eines Steckkontakts für eine einfache Verbindung des Radarmoduls 100 zu einem Steuergerät eines Fahrzeugs genutzt werden.

Fig. 5 zeigt einen Detailausschnitt des in Fig. 4 gezeigten elektrischen Schaltungsmoduls 100 im SemiFlex-Aufbau.

Die in den Figuren 1, 3, 4 und 5 gezeigten beispielhaften elektrischen Schaltungsmodule 100 sind gemäß Ausführungsbeispielen auf der Basis von gemäß bekannten Leiterplattentechnologien strukturierten Hochfrequenzfolien aufgebaut. Die Folien können je nach Spezifikation ein-, zwei- oder auch mehrlagig hergestellt sein. Die Montage der elektronischen und Hochfrequenzkomponenten kann in kostengünstiger planarer Technik erfolgen. Ein Schutz der Elektronik kann ohne Weiteres durch Einlaminieren der HF-Komponenten erreicht werden. Die Herstellung von mehrlagigen Aufbauten für die Auswerteelektronik erfolgt gemäß Ausführungsbeispielen durch Laminiertechnologie und galvanisches Verbinden des Interposers. Prinzipiell ist die Anordnung von mehreren HF-Modulen auf einer Folie realisierbar.

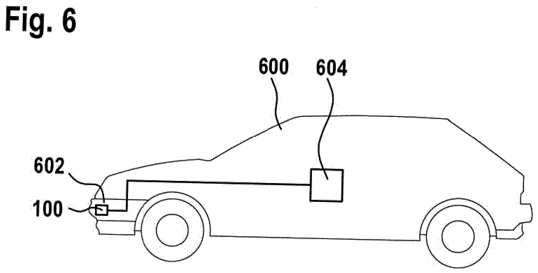

Fig. 6 zeigt anhand einer schematischen Darstellung einen möglichen Einsatz des gemäß dem hier vorgestellten Konzept gefertigten elektrischen Schaltungsmoduls 100 als Radarsensor oder Teil eines Radarsensors in einem Fahrzeug 600. Bei dem Fahrzeug 600 handelt es sich hier um ein straßengebundenes Fahrzeug 600 wie einen Personen- oder Lastkraftwagen. Das elektrische Schaltungsmodul 100 ist für eine Radarerfassung von im Umfeld des Fahrzeugs 600 befindlichen Objekten in einem Stoßfänger 602 des Fahrzeugs 600 verdeckt eingebaut.

Über ein Leitungssystem, z. B. einen CAN-Bus, des Fahrzeugs 600 ist das elektrische Schaltungsmodul 100 mit einem zentralen Steuergerät 604 des Fahrzeugs 600 verbunden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (200) zum Herstellen eines elektrischen Schaltungsmoduls (100), wobei das Verfahren (200) die folgenden Schritte aufweist:
Bereitstellen (204) eines Schaltungsträgers (102) mit zumindest einem auf einer ersten Hauptseite (108) des Schaltungsträgers (102) angeordneten Antennenelement (104; 306) zum Aussenden elektromagnetischer Strahlung und zumindest einem auf einer zweiten Hauptseite (110) des Schaltungsträgers (102) angeordneten elektrischen Kontakt (112);
Bereitstellen (206) einer in Embedded-Wafer-Level-Ball-Grid-Array-Technologie hergestellten elektronischen Schaltung (106) in Form einer in Embedded-Wafer-Level-Ball-Grid-Array-Technologie hergestellten elektronischen Hochfrequenzschaltung; und
Anordnen (208) der elektronischen Schaltung (106) mit einer Kontaktierseite (114) der elektronischen Schaltung (106) an der zweiten Hauptseite (110) des Schaltungsträgers (102), um die Kontaktierseite (114) mit dem elektrischen Kontakt (112) elektrisch leitfähig zu kontaktieren,
**dadurch gekennzeichnet, dass**
in dem Schritt des Bereitstellens (204) eines Schaltungsträgers (102) der Schaltungsträger (102) mit zumindest einer ersten Schaltungsträgerlage (302) und einer auf die erste Schaltungsträgerlage (302) auflaminierten zweiten Schaltungsträgerlage (304) bereitgestellt wird, wobei die erste Schaltungsträgerlage (302) die erste Hauptseite (108) des Schaltungsträgers (102) aufweist und die zweite Schaltungsträgerlage (304) die zweite Hauptseite (110) des Schaltungsträgers (102) aufweist, wobei in dem Schritt des Bereitstellens (204) eines Schaltungsträgers (102) die erste Schaltungsträgerlage (302) und die zweite Schaltungsträgerlage (304) als eine Folie mit einer Dicke im Bereich zwischen 25 µm und 150 µm ausgebildet bereitgestellt wird.

2. Verfahren (200) gemäß Anspruch 1, bei dem in dem Schritt des Bereitstellens (204) eines Schaltungsträgers (102) die erste Schaltungsträgerlage (302) ein Material mit einer Dielektrizitätszahl in einem Bereich zwischen 2,5 und 3,5, insbesondere mit einer Dielektrizitätszahl von 3, und/oder mit einem Verlustfaktorwert in einem Bereich zwischen 0,0010 und 0,0025, insbesondere mit einem Verlustfaktorwert von 0,0017 aufweist.

3. Verfahren (200) gemäß einem der vorangegangenen Ansprüche, bei dem in dem Schritt des Bereitstellens (204) eines Schaltungsträgers (102) die zweite Schaltungsträgerlage (304) ein mit Reaktionsharzen vorimprägniertes textiles Halbzeug aufweist.

4. Verfahren (200) gemäß einem der vorangegangenen Ansprüche, bei dem in dem Schritt des Bereitstellens (204) eines Schaltungsträgers (102) der Schaltungsträger (102) mit zumindest einer zwischen der ersten Schaltungsträgerlage (302) und der zweiten Schaltungsträgerlage (304) einlaminierten elektrischen Leitung (112) bereitgestellt wird.

5. Verfahren (200) gemäß einem der vorangegangenen Ansprüche, mit einem Schritt des Herstellens (202) des Schaltungsträgers (102), wobei eine erste Schaltungsträgerlage (302) für den Schaltungsträger (102) bereitgestellt wird und eine zweite Schaltungsträgerlage (304) für den Schaltungsträger (102) auf die erste Schaltungsträgerlage (302) auflaminiert wird, um die erste Schaltungsträgerlage (302) und die zweite Schaltungsträgerlage (304) stoffschlüssig zu verbinden.

6. Verfahren (200) gemäß einem der vorangegangenen Ansprüche, mit einem Schritt des Fixierens (210) der elektronischen Schaltung (106) an dem Schaltungsträger (102), um die elektronische Schaltung (106) dauerhaft an dem Schaltungsträger (102) zu befestigen.

7. Verfahren (200) gemäß Anspruch 6, bei dem in dem Schritt des Fixierens (210) zumindest ein an der Kontaktierseite (114) der elektronischen Schaltung (106) angeordneter Kontaktierhügel (308) der elektronischen Schaltung (106) an den elektrischen Kontakt (112) des Schaltungsträgers (102) angebracht, insbesondere angelötet, angeklebt oder angeschweißt wird.

8. Verfahren (200) gemäß Anspruch 6, bei dem in dem Schritt des Fixierens zumindest eine an der Kontaktierseite (114) der elektronischen Schaltung (106) angeordnete elektrische Leitung der elektronischen Schaltung (106) galvanisch an den elektrischen Kontakt (112) des Schaltungsträgers (102) ankontaktiert wird.

9. Verfahren (200) gemäß einem der vorangegangenen Ansprüche, mit einem Schritt des Auflegens (212) des Schaltungsträgers (102) mit der zweiten Hauptseite (110) auf ein flüssiges oder pastöses Verbundmaterial (300), um eine die elektronische Schaltung (106) einbettende Leiterplatte (311) des elektronischen Schaltungsmoduls (100) zu bilden.

10. Verfahren (200) gemäß Anspruch 9, bei dem in dem Schritt des Auflegens (212) der Schaltungsträger (102) auf ein Verbundmaterial (300) aufgelegt wird, das Epoxidharz und Glasfasergewebe aufweist.

11. Verfahren (200) gemäß einem der vorangegangenen Ansprüche, mit einem Schritt des Ausfräsens (214) eines seitlich an die elektronische Schaltung (106) angrenzenden Teilbereichs zumindest des Schaltungsträgers (102), um die elektronische Schaltung (106) zumindest teilweise seitlich freizulegen und ein Abbiegen von Antennenstrukturen ermöglicht.

12. Elektrisches Schaltungsmodul (100) mit folgenden Merkmalen:
einem Schaltungsträger (102) mit zumindest einem auf einer ersten Hauptseite (108) des Schaltungsträgers (102) angeordneten Antennenelement (104; 306) zum Aussenden elektromagnetischer Strahlung und zumindest einem auf einer zweiten Hauptseite (110) des Schaltungsträgers (102) angeordneten elektrischen Kontakt (112); und
einer in Embedded-Wafer-Level-Ball-Grid-Array-Technologie hergestellten elektronischen Schaltung (106) in Form einer in Embedded-Wafer-Level-Ball-Grid-Array-Technologie hergestellten elektronischen Hochfrequenzschaltung, die mit einer Kontaktierseite (114) der elektronischen Schaltung (106) an der zweiten Hauptseite (110) des Schaltungsträgers (102) angeordnet ist und den elektrischen Kontakt (112) elektrisch leitfähig kontaktiert,
**dadurch gekennzeichnet, dass**
der Schaltungsträger (102) zumindest eine erste Schaltungsträgerlage (302) und eine auf die erste Schaltungsträgerlage (302) auflaminierte zweite Schaltungsträgerlage (304) aufweist, wobei die erste Schaltungsträgerlage (302) die erste Hauptseite (108) des Schaltungsträgers (102) aufweist und die zweite Schaltungsträgerlage (304) die zweite Hauptseite (110) des Schaltungsträgers (102) aufweist, wobei die erste Schaltungsträgerlage (302) und die zweite Schaltungsträgerlage (304) als eine Folie mit einer Dicke im Bereich zwischen 25 µm und 150 µm ausgebildet ist.

## Claims

1. Method (200) for producing an electrical circuit module (100), wherein the method (200) comprises the following steps:
providing (204) a circuit carrier (102) having at least one antenna element (104; 306), arranged on a first main side (108) of the circuit carrier (102), for emitting electromagnetic radiation and at least one electrical contact (112), arranged on a second main side (110) of the circuit carrier (102);
providing (206) an electronic circuit (106), produced using embedded wafer level ball grid array technology, in the form of an electronic high-frequency circuit, produced using embedded wafer level ball grid array technology; and
arranging (208) the electronic circuit (106) by way of a contact-making side (114) of the electronic circuit (106) on the second main side (110) of the circuit carrier (102) in order to electrically conductively contact-connect the contact-making side (114) to the electrical contact (112),
**characterized in that**,
in the step of providing (204) a circuit carrier (102), the circuit carrier (102) is provided with at least one first circuit carrier layer (302) and a second circuit carrier layer (304) laminated to the first circuit carrier layer (302), wherein the first circuit carrier layer (302) comprises the first main side (108) of the circuit carrier (102) and the second circuit carrier layer (304) comprises the second main side (110) of the circuit carrier (102), wherein, in the step of providing (204) a circuit carrier (102), the first circuit carrier layer (302) and the second circuit carrier layer (304) are provided designed as a film having a thickness in the range between 25 µm and 150 µm.

2. Method (200) according to Claim 1, wherein, in the step of providing (204) a circuit carrier (102), the first circuit carrier layer (302) comprises a material having a dielectric number in a range between 2.5 and 3.5, in particular having a dielectric number of 3, and/or having a loss factor value in a range between 0.0010 and 0.0025, in particular having a loss factor value of 0.0017.

3. Method (200) according to either one of the preceding claims, wherein, in the step of providing (204) a circuit carrier (102), the second circuit carrier layer (304) comprises a semi-finished textile product pre-impregnated with reaction resins.

4. Method (200) according to any one of the preceding claims, wherein, in the step of providing (204) a circuit carrier (102), the circuit carrier (102) is provided with at least one electrical line (112) laminated between the first circuit carrier layer (302) and the second circuit carrier layer (304).

5. Method (200) according to any one of the preceding claims, having a step of producing (202) the circuit carrier (102), wherein a first circuit carrier layer (302) is provided for the circuit carrier (102) and a second circuit carrier layer (304) for the circuit carrier (102) is laminated to the first circuit carrier layer (302) in order to connect the first circuit carrier layer (302) and the second circuit carrier layer (304) in an integrally bonded manner.

6. Method (200) according to any one of the preceding claims, having a step of fixing (210) the electronic circuit (106) to the circuit carrier (102) in order to permanently attach the electronic circuit (106) to the circuit carrier (102).

7. Method (200) according to Claim 6, wherein, in the fixing step (210), at least one bump (308) of the electronic circuit (106) arranged on the contact-making side (114) of the electronic circuit (106) is attached, in particular soldered, adhesively bonded or welded, to the electrical contact (112) of the circuit carrier (102).

8. Method (200) according to Claim 6, wherein, in the fixing step, at least one electrical line of the electronic circuit (106) arranged on the contact-making side (114) of the electronic circuit (106) is electrically contact-connected to the electrical contact (112) of the circuit carrier (102).

9. Method (200) according to any one of the preceding claims, having a step of applying (212) the circuit carrier (102) by way of the second main side (110) to a liquid or pasty composite material (300) in order to form a printed circuit board (311) of the electronic circuit module (100) embedding the electronic circuit (106).

10. Method (200) according to Claim 9, wherein, in the application step (212), the circuit carrier (102) is applied to a composite material (300) comprising epoxy resin and glass fibre fabric.

11. Method (200) according to any one of the preceding claims, having a step of milling (214) a section of at least the circuit carrier (102) laterally adjacent to the electronic circuit (106) in order to at least partially expose the electronic circuit (106) laterally and enable bending of antenna structures.

12. Electrical circuit module (100) having the following features:
a circuit carrier (102) having at least one antenna element (104; 306), arranged on a first main side (108) of the circuit carrier (102), for emitting electromagnetic radiation and at least one electrical contact (112), arranged on a second main side (110) of the circuit carrier (102); and
an electronic circuit (106), produced using embedded wafer level ball grid array technology, in the form of an electronic high-frequency circuit, produced using embedded wafer level ball grid array technology, said high-frequency circuit being arranged on the second main side (110) of the circuit carrier (102) by way of a contact-making side (114) of the electronic circuit (106) and electrically conductively contact-connecting the electrical contact (112),
**characterized in that**
the circuit carrier (102) has at least one first circuit carrier layer (302) and a second circuit carrier layer (304) laminated to the first circuit carrier layer (302), wherein the first circuit carrier layer (302) comprises the first main side (108) of the circuit carrier (102) and the second circuit carrier layer (304) comprises the second main side (110) of the circuit carrier (102), wherein the first circuit carrier layer (302) and the second circuit carrier layer (304) are designed as a film having a thickness in the range between 25 µm and 150 µm.

## Revendications

1. Procédé (200) de fabrication d'un module de commutation électrique (100), le procédé (200) présentant les étapes suivantes consistant à :
fournir (204) un support de circuit (102) pourvu d'au moins un élément d'antenne (104 ; 306), disposé sur une première face principale (108) du support de circuit (102), pour émettre un rayonnement électromagnétique, et d'au moins un contact électrique (112) disposé sur une deuxième face principale (110) du support de circuit (102) ;
fournir (206) un circuit électronique (106) fabriqué selon une technologie Embedded Wafer Level Ball Grid Array sous la forme d'un circuit haute fréquence électronique fabriqué selon la technologie Embedded Wafer Level Ball Grid Array ; et
disposer (208) le circuit électronique (106) avec une face de contact (114) du circuit électronique (106) sur la deuxième face principale (110) du support de circuit (102) pour mettre en contact de manière électriquement conductrice le côté de mise en contact (114) avec le contact électrique (112),
**caractérisé en ce**
**qu'**à l'étape de fourniture (204) d'un support de circuit (102), le support de circuit (102) est fourni avec au moins une première couche de support de circuit (302) et une deuxième couche de support de circuit (304) laminée sur la première couche de support de circuit (302), dans lequel la première couche de support de circuit (302) présente la première face principale (108) du support de circuit (102) et la deuxième couche de support de circuit (304) présente la deuxième face principale (110) du support de circuit (102), dans lequel à l'étape de fourniture (204) d'un support de circuit (102), la première couche de support de circuit (302) et la deuxième couche de support de circuit (304) sont fournies en étant réalisées sous la forme d'une feuille d'une épaisseur dans la plage comprise entre 25 µm et 150 µm.

2. Procédé (200) selon la revendication 1, dans lequel à l'étape de fourniture (204) d'un support de circuit (102), la première couche de support de circuit (302) présente un matériau ayant une constante diélectrique dans une plage comprise entre 2,5 et 3,5, en particulier une constante diélectrique de 3, et/ou une valeur de facteur de perte dans une plage comprise entre 0,0010 et 0,0025, en particulier une valeur de facteur de perte de 0,0017.

3. Procédé (200) selon l'une quelconque des revendications précédentes, dans lequel à l'étape de fourniture (204) d'un support de circuit (102), la deuxième couche de support de circuit (304) présente un produit textile semi-fini pré-imprégné avec des résines de réaction.

4. Procédé (200) selon l'une quelconque des revendications précédentes, dans lequel à l'étape de fourniture (204) d'un support de circuit (102), le support de circuit (102) est fourni avec au moins une ligne électrique (112) laminée entre la première couche de support de circuit (302) et la deuxième couche de support de circuit (304).

5. Procédé (200) selon l'une quelconque des revendications précédentes, comprenant une étape de fabrication (202) du support de circuit (102), dans lequel une première couche de support de circuit (302) est fournie pour le support de circuit (102), et une deuxième couche de support de circuit (304) pour le support de circuit (102) est laminée sur la première couche de support de circuit (302) pour relier la première couche de support de circuit (302) et la deuxième couche de support de circuit (304) par liaison de matière.

6. Procédé (200) selon l'une quelconque des revendications précédentes, comprenant une étape de fixation (210) du circuit électronique (106) au support de circuit (102) pour fixer le circuit électronique (106) au support de circuit (102) de manière permanente.

7. Procédé (200) selon la revendication 6, dans lequel à l'étape de fixation (210), au moins un bossage de contact (308) du circuit électronique (106), disposé sur la face de mise en contact (114) du circuit électronique (106), est fixé, en particulier brasé, collé ou soudé, au contact électrique (112) du support de circuit (102).

8. Procédé (200) selon la revendication 6, dans lequel à l'étape de fixation, au moins une ligne électrique du circuit électronique (106), disposée sur la face de mise en contact (114) du circuit électronique (106), est mise en contact galvanique avec le contact électrique (112) du support de circuit (102).

9. Procédé (200) selon l'une quelconque des revendications précédentes, comprenant une étape de pose (212) du support de circuit (102) avec la deuxième face principale (110) sur un matériau composite (300) liquide ou pâteux pour former une carte de circuits imprimés (311), incorporant le circuit électronique (106), du module de commutation électronique (100).

10. Procédé (200) selon la revendication 9, dans lequel à l'étape de pose (212), le support de circuit (102) est posé sur un matériau composite (300) qui présente de la résine époxy et du tissu de verre.

11. Procédé (200) selon l'une quelconque des revendications précédentes, comprenant une étape de fraisage (214) d'une zone partielle, latéralement adjacente au circuit électronique (106), au moins du support de circuit (102) pour exposer latéralement au moins en partie le circuit électronique (106) et permettre de dévier les structures d'antenne.

12. Module de circuit électrique (100) ayant les particularités suivantes :
un support de circuit (102) avec au moins un élément d'antenne (104 ; 306) disposé sur une première face principale (108) du support de circuit (102) pour émettre un rayonnement électromagnétique et au moins un contact électrique (112) disposé sur une deuxième face principale (110) du support de circuit (102) ; et
un circuit électronique (106) fabriqué selon la technologie Embedded Wafer Level Ball Grid Array sous la forme d'un circuit haute fréquence électronique fabriqué selon la technologie Embedded Wafer Level Ball Grid Array qui est disposé par une face de mise en contact (114) du circuit électronique (106) sur la deuxième face principale (110) du support de circuit (102) et met le contact électrique (112) en contact de manière électriquement conductrice,
caractérisé en ce
le support de circuit (102) présente au moins une première couche de support de circuit (302) et une deuxième couche de support de circuit (304) laminée sur la première couche de support de circuit (302), dans lequel la première couche de support de circuit (302) présente la première face principale (108) du support de circuit (102) et la deuxième couche de support de circuit (304) présente la deuxième face principale (110) du support de circuit (102), dans lequel la première couche de support de circuit (302) et la deuxième couche de support de circuit (304) sont réalisées sous la forme d'une feuille d'une épaisseur dans la plage comprise entre 25 µm et 150 µm.
